(19) Europäisches Patentamt
European Patent Office
Office européen des brevets

(11) Veröffentlichungsnummer : **0 157 930**
**B1**

(12) # EUROPÄISCHE PATENTSCHRIFT

(45) Veröffentlichungstag der Patentschrift : **23.03.88**

(21) Anmeldenummer : **84115193.9**

(22) Anmeldetag : **12.12.84**

(51) Int. Cl.[4] : **G 03 F 7/10**, G 03 F 7/26, G 03 C 1/70, C 08 G 73/06, C 08 G 73/12

(54) **Verfahren zur Herstellung von Polyimid- und Polyisoindolochinazolindion-Reliefstrukturen.**

(30) Priorität : **29.03.84 DE 3411697**

(43) Veröffentlichungstag der Anmeldung : **16.10.85 Patentblatt 85/42**

(45) Bekanntmachung des Hinweises auf die Patenterteilung : **23.03.88 Patentblatt 88/12**

(84) Benannte Vertragsstaaten : **AT BE CH DE FR GB IT LI NL SE**

(56) Entgegenhaltungen :
**DE-A- 2 308 830**
**DE-A- 2 933 827**
**DE-B- 1 202 981**

(73) Patentinhaber : **Siemens Aktiengesellschaft Berlin und München**
**Wittelsbacherplatz 2**
**D-8000 München 2 (DE)**

(72) Erfinder : **Ahne, Hellmut, Dr.**
**Heidestrasse 6**
**D-8551 Röttenbach (DE)**

**EP 0 157 930 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein Verfahren zur Herstellung hochwärmebeständiger Polyimid- und Polyisoindolochinazolindion-Reliefstrukturen durch Auftragen strahlungsempfindlicher löslicher Polymer-Vorstufen in Form einer Schicht oder Folie auf ein Substrat wobei als Polymer-Vorstufen olefinisch ungesättigte Polyamidocarbonsäureester dienen, Bestrahlen der Schicht bzw. Folie durch Negativvorlagen mit aktinischem Licht oder Elektronen oder durch Führen eines Licht-, Elektronen-, Ionen- oder Laserstrahls, Entfernen der nichtbestrahlten Schicht- bzw. Folienteile und gegebenenfalls durch nachfolgendes Tempern, sowie die Verwendung dieser Reliefstrukturen.

Photostrukturierte Polyimid- und Polyisoindolochinazolindion-Schichten werden beispielsweise in der Halbleiterindustrie als Isolier- und Schutzschichten eingesetzt. Aufgrund des starken Kostendruckes auf dem Halbleitersektor wird zur Herstellung derartiger Schichten der Einsatz kostengünstiger Materialien und Verfahren angestrebt. Deshalb kommt für den genannten Zweck auch die indirekte Photostrukturierung von Polyimid- und Polyisoindolochinazolindion-Schichten mittels konventioneller Photoresists weniger in Betracht, weil dieses Verfahren viele Schritte erfordert und damit sehr aufwendig ist.

Aus der DE-C 23 08 830 ist ein Verfahren der genannten Art zur Herstellung von Polyimid- und Polyisoindolochinazolindion-Reliefstrukturen bekannt. Bei diesem Verfahren werden als lösliche Polymer-Vorstufen Polykondensationsprodukte polyfunktioneller carbocyclischer oder heterocyclischer, strahlungsempfindliche Reste tragender Verbindungen mit Diaminen verwendet. Die Verbindungen, die strahlungsempfindliche Reste tragen, enthalten dabei zwei für Kondensationsreaktionen geeignete Carbonsäurechloridgruppen und teilweise in orthooder peri-Stellung dazu esterartig an Carboxylgruppen gebundene strahlungsreaktive Gruppen. Die mit diesen Verbindungen umzusetzenden Diamine weisen mindestens ein cyclisches Strukturelement auf.

Die löslichen Polymer-Vorstufen werden beim Bestrahlen vernetzt und gehen dabei in unlösliche Zwischenprodukte über. Diese Zwischenprodukte unterliegen bei der Temperung einer Cyclisierung, wobei hochwärmebeständige Polyimide bzw. Polyisoindolochinazolindione gebildet werden.

Die nach dem bekannten Verfahren hergestellten Reliefstrukturen haben sich in der Praxis gut bewährt. Allerdings weisen die dabei verwendeten Polymer-Vorstufen, bedingt durch das Herstellungsverfahren, bei dem Säurechloride eingesetzt werden, auch nach gründlicher Reinigung noch einen geringen Restchlorgehalt auf. Dieser Restchlorgehalt kann sich bei extremen Bauteilanforderungen, wie zum Beispiel in direktem Kontakt zu P-N-Übergängen bei MOS-Bauteilen, störend auswirken.

Zur Herstellung hochwärmebeständiger Polyimid- und Polyisoindolochinazolindion-Reliefstrukturen ist ferner ein Verfahren bekannt, bei dem als Polymer-Vorstufen Additionsprodukte von olefinisch ungesättigten Monoepoxiden an carboxylgruppenhaltige Polyadditionsprodukte aus aromatischen und/oder heterocyclischen Tetracarbonsäuredianhydriden und Diaminoverbindungen oder Diaminoverbindungen mit wenigstens einer ortho-ständigen Amidogruppe verwendet werden (DE-A 29 33 827). Synthesebedingt weisen diese Polymer-Vorstufen jedoch einen relativ geringen Anteil an photoempfindlichen Gruppen auf, woraus eine begrenzte Photoempfindlichkeit resultiert.

Aufgabe der Erfindung ist es, das Verfahren der eingangs genannten Art zur Herstellung von Polyimid- und Polyisoindolochinazolindion-Reliefstrukturen dahingehend weiter zu verbessern, daß auf preisgünstige Weise hochreine, insbesondere chloridfreie Reliefstrukturen bei gleichzeitig wirtschaftlich attraktiven Belichtungszeiten hergestellt werden können.

Dies wird erfindungsgemäß dadurch erreicht, daß als Polymer-Vorstufen in Gegenwart von Carbodiimiden hergestellte Polykondensationsprodukte von Diaminoverbindungen oder Diaminoverbindungen mit wenigstens einer ortho-ständigen Amidogruppe und olefinisch ungesättigten Tetracarbonsäurediestern in Form von Additionsprodukten aus aromatischen und/oder heterocyclischen Tetracarbonsäuredianhydriden und olefinisch ungesättigten Alkoholen verwendet werden.

Das erfindungsgemäße Verfahren erlaubt eine kostengünstige Erzeugung hochreiner, d.h. insbesondere chloridfreier Reliefstrukturen, wobei auch besonders wesentlich ist, daß die dabei erforderlichen Belichtungszeiten eine besonders wirtschaftliche Strukturerzeugung ermöglichen. Vorteilhaft bei diesem Verfahren ist ferner, daß als Entwickler auch mit Wasser mischbare, schwer brennbare Lösungsmittel verwendet werden können und somit kostenaufwendige Sicherheitsmaßnahmen, wie Explosionsschutz, entfallen. Darüber hinaus können die nach dem erfindungsgemäßen Verfahren hergestellten Reliefstrukturen mittels eines einfachen Temperprozesses in hochwärmebeständige Reliefstrukturen mit einer dauerhaften Schutz- und Isolierfunktion, beispielsweise in Halbleiterbauteilen, übergeführt werden. Außerdem ist beim erfindungsgemäßen Verfahren der durch einen einzigen Auftrag erzeugbare Schichtdickenbereich für einen Photolack ungewöhnlich groß, so daß hierbei auf einfache Weise auch sehr dicke Schichten erzeugt werden können, beispielsweise als α-Strahlenschutz für Speicherbausteine.

Beim erfindungsgemäßen Verfahren können die Polymer-Vorstufen vorteilhaft zusammen mit licht- oder strahlungsempfindlichen copolymerisationsfähigen Verbindungen eingesetzt werden. Dazu werden vorzugsweise N-substituierte Maleinimide verwendet. Es können aber auch acrylat- bzw. methacrylatgruppenhaltige Verbindungen eingesetzt werden. Weiter können auch Photoinitiatoren und/oder -sensibilisatoren verwendet werden (vgl. : « Industrie Chimique Belge », 24, 1959, S. 739 bis 764, sowie J. Kosar, « Light-Sensitive Systems », John Wiley & Sons Inc., New York 1965, S. 143 bis 146 und S. 160 bis 188). Besonders geeignet sind Imidazole, insbesondere Benzimidazole, und Ketocumarine sowie Michlers Keton ; es eignen sich beispielsweise aber auch Benzoinether, 2-tert.Butyl-9.10-anthrachinon, 1.2-Benz-9.10-anthrachinon und 4.4'-Bis(diethylamino)-benzophenon. Ferner können beim erfindungsgemäßen Verfahren vorteilhaft Haftvermittler verwendet werden. Dazu dienen insbesondere Silane, wie Vinyltriethoxysilan, Vinyl-tris(β-methoxyethoxy)-silan, γ-Methacryloxypropyl-trimethoxysilan und γ-Glycidoxy-propyltrimethoxysilan.

Die beim erfindungsgemäßen Verfahren eingesetzten strahlungsreaktiven Vorstufen, die oligomerer und/oder polymerer Natur sind, sind in der gleichzeitig eingereichten europäischer Patentanmeldung « Verfahren zur Herstellung von Polyimid- und Polyisoindolochinazolindion-Vorstufen », Anmeldenummer 84115192.1 (EP-A-0157929), beschrieben. Diese Vorstufen weisen im allgemeinen folgende Struktur auf :

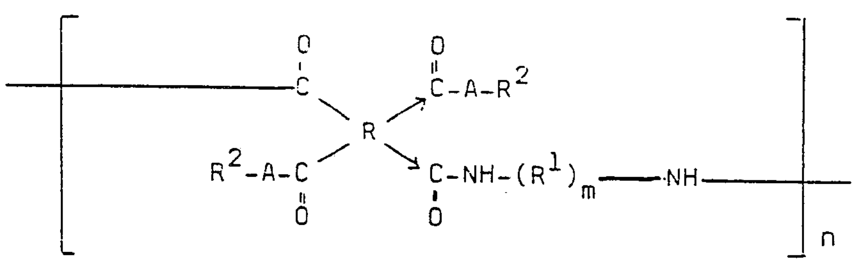

Mit den in der Formel enthaltenen Pfeilen soll dabei die Tatsache zum Ausdruck gebracht werden, daß die beiden fraglichen Substituenten an R ihre Stellung vertauschen können. Dies ist deshalb von Bedeutung, weil es sich bei R, wie nachfolgend noch erläutert wird, um einen cyclischen Rest handelt.

In der Formel bedeutet n eine ganze Zahl von 2 bis etwa 100 und m ist 0 oder 1.

Für R, $R^1$, $R^2$ und A gilt folgendes :

R ist ein - gegebenenfalls halogenierter - zumindest partiell aromatischer und/oder heterocyclischer tetravalenter, d.h. tetrafunktioneller Rest, bei dem jeweils zwei Valenzen in Nachbarstellung zueinander angeordnet sind ; weist der Rest R mehrere aromatische und/oder heterocyclische Strukturelemente auf, so befinden sich die Valenzpaare jeweils an endständigen derartigen Strukturelementen ;

$R^1$ ist ein - gegebenenfalls halogenierter - divalenter, d.h. difunktioneller Rest aliphatischer und/oder cycloaliphatischer, gegebenenfalls Heteroatome aufweisender, und/oder aromatischer und/oder heterocyclischer Struktur ;

$R^2$ ist ein olefinisch ungesättigter Rest, beispielsweise eine allyletherhaltige Gruppe, insbesondere eine - gegebenenfalls substituierte - (meth)acrylesterhaltige Gruppe oder eine Propargylgruppe ;

A bedeutet —O— oder —NH—.

Bei der Bestrahlung mit Licht werden dabei Kondensationsprodukte aus methacrylat- und/oder acrylatgruppenhaltigen Pyromellithsäure- und/oder Benzophenontetracarbonsäurediestern mit 4.4'-Diaminodiphenylether oder 4.4'-Diaminodiphenyl-3.3'-dicarbonsäureamid bevorzugt, bei Bestrahlung mit Elektronen entsprechende propargylgruppenhaltige Kondensationsprodukte.

Die Herstellung der erfindungsgemäßen Reliefstrukturen erfolgt, wie bereits ausgeführt, in der Weise, daß die Polymer-Vorstufe in Form einer Schicht oder Folie auf ein Substrat aufgebracht und mit aktinischem Licht oder mit Elektronen durch eine Maske belichtet oder durch Führen eines Licht-, Elektronen-, Ionen- oder Laserstrahls bestrahlt wird ; anschließend werden die nichtbelichteten bzw. nichtbestrahlten Schicht- oder Folienteile herausgelöst oder abgezogen und die dabei erhaltenen Reliefstrukturen werden gegebenenfalls getempert. Die Vorstufe kann vorteilhaft in einem organischen Lösungsmittel gelöst auf das Substrat aufgebracht werden ; vorzugsweise wird als Lösungsmittel N-Methylpyrrolidon verwendet. Die Konzentration der Lösung kann so eingestellt werden, daß mit bekannten Beschichtungsverfahren, wie Schleudern, Tauchen, Sprühen, Bürsten oder Rollen, Schichtstärken von 0,01 µm bis einige 100 µm erzeugt werden können. Es hat sich gezeigt, daß beispielsweise beim Schleuderbeschichten 300 bis 10 000 Umdrehungen pro Minute für die Dauer von 1 bis 100 s geeignet sind, um eine gleichmäßige und gute Oberflächenqualität zu erzielen. Die auf das Substrat, das vorzugsweise aus Glas, Metall, Kunststoff oder halbleitendem Material besteht, aufgebrachte Photoresistschicht kann bei Raumtemperatur oder bei erhöhter Temperatur, vorzugsweise bei einer Temperatur von 25 bis 60°C, in einem Stickstoff- oder Luftstrom vom Lösungsmitel befreit werden ; dabei kann vorteilhaft auch im Vakuum gearbeitet werden.

Zur Erzielung eines ausreichenden Löslichkeitsunterschiedes zwischen den bestrahlten und den nichtbestrahlten Schicht- bzw. Folienteilen genügen beim erfindungsgemäßen Verfahren - bei der Verwendung einer 300 W- bzw. einer 500 W-Quecksilberhöchstdrucklampe - in Abhängigkeit von der Zusammensetzung und der Schichtstärke Belichtungszeiten zwischen 10 und 800 s. Nach dem Belichten werden die nichtbelichteten Teile der Schicht bzw. Folie herausgelöst, vorzugsweise mit einem

organischen, schwer brennbaren Entwickler.

Mittels des erfindungsgemäßen Verfahrens werden außergewöhnlich konturenscharfe Bilder, d.h. Reliefstrukturen, erhalten, die durch Temperung in hochwärmebeständige, gegenüber Säuren und Laugen resistente Polymere umgewandelt werden. Im allgemeinen können Temperaturen von 150 bis 500°C gewählt werden, vorzugsweise wird bei Temperaturen von 300 bis 400°C getempert. Die Temperzeit beträgt im allgemeinen eine halbe Stunde, wobei unter Inertgas keine Verfärbung zu beobachten ist. Die Kantenschärfe und die Maßgenauigkeit der Reliefstrukturen werden durch die Temperung praktisch nicht beeinträchtigt. Darüber hinaus bleibt die gute Oberflächenqualität der Reliefstrukturen trotz eines beim Tempern eintretenden Schichtstärkenverlustes erhalten.

Die beim erfindungsgemäßen Verfahren eingesetzten strahlungsreaktiven Vorstufen sind - in Gegenwart von Carbodiimid hergestellte - Polykondensationsprodukte von olefinisch ungesättigten difunktionellen Diestern, in Form von Additionsprodukten aus Tetracarbonsäure-dianhydriden und ungesättigten Alkoholen, mit Diaminen (Polyimid-Vorstufen) bzw. mit o-Aminoamiden, d.h. Diaminen mit ortho-ständigen Amidogruppen (Polyisoindolochinazolindion-Vorstufen). Zur Herstellung der Diester werden dabei als Tetracarbonsäuredianhydrid bevorzugt das Anhydrid der Pyrromellithsäure und der Benzophenontetracarbonsäure eingesetzt, als ungesättigter Alkohol bevorzugt Hydroxyethylacrylat und Hydroxyethylmethacrylat. Bei den Diaminoverbindungen ist der 4.4'-Diaminodiphenylether bevorzugt, bei den o-Aminoamiden das 4.4'-Diaminodiphenyl-3.3'-dicarbonsäureamid. Das bevorzugt verwendete Carbodiimid ist Dicyclohexylcarbodiimid ; Carbodiimide sind im übrigen Verbindungen vom Typ R'—N=C=N—R".

Beim erfindungsgemäßen Verfahren werden vorzugsweise Polymer-Vorstufen aus aromatischen Komponenten eingesetzt, so daß bei der thermischen Behandlung, d.h. bei der Temperung, Polymere mit folgenden Struktureinheiten gebildet werden :

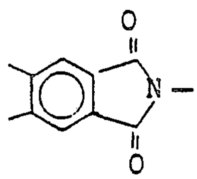 ; 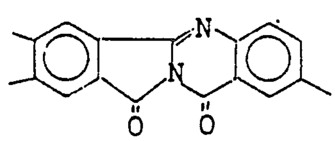

Polyimid — Polyisoindolochinazolindion

Die genannten Verbindungsklassen zählen zu den Halb-Leiterpolymeren bzw. Leiterpolymeren und zeichnen sich durch eine hohe Temperaturbeständigkeit aus (bis zu ca. 500°C).

Die erfindungsgemäßen Reliefstrukturen können zur Herstellung von Passivierungsschichten auf Halbleiterbauelementen, von Dünn- und Dickfilmschaltungen, von Lötschutzschichten auf Mehrlagenschaltungen, von Isolierschichten als Bestandteil von Schichtschaltungen und von miniaturisierten Schutz- und Isolierschichten auf elektrisch leitenden und/oder halbleitenden und/oder isolierenden Basismaterialien, insbesondere im Bereich der Mikroelektronik oder allgemein für die Feinstrukturierung von Substraten, Anwendung finden. Vorzugsweise dienen die hochwärmebeständigen Reliefstrkturen als Masken für Naß- und Trockenätzprozesse, stromlose oder galvanische Metallabscheidung und Aufdampfverfahren sowie - in Form sehr dicker, strukturierter Schichten - als α-Strahlenschutz auf den Zellenfeldern von Speicherbausteinen und als extrem dünne Flüssigkristallorientierungsschichten in Flüssigkristalldisplays.

Anhand von Ausführungsbeispielen soll die Erfindung noch näher erläuterte werden.

### Beispiel 1

Herstellung einer strahlungsreaktiven Polyimid-Vorstufe.

Zu 32,2 Gewichtsteilen Benzophenontetracarbonsäuredianhydrid (0,1 Mol) in 50 Volumenteilen γ-Butyrolacton werden unter Rühren und Feuchtigkeitsausschluß 26 Gewichtsteile Hydroxyethylmethacrylat (0,2 Mol) und 0,2 Gewichtsteile 1.4-Diazabicyclo(2.2.2)octan gegeben. Nach 16stündigem Stehenlassen beträgt der titrimetrisch ermittelte Carboxylgehalt 0,22 Mol/100 g. Unter Rühren wird dann zur Reaktionslösung eine Lösung von 16 Gewichtsteilen 4,4'-Diaminodiphenylether (0,08 Mol) in 50 Volumenteilen N-Methylpyrrolidon gegeben. Danach wird in die Reaktionslösung eine Lösung von 36 Gewichtsteilen Dicyclohexylcarbodiimid (0,18 Mol) in 100 Volumenteilen γ-Butyrolacton getropft. Der sich dabei bildende Dicyclohexylharnstoff fällt als Niederschlag aus. Die Reaktionslösung wird dann bei Raumtemperatur über Nacht stehengelassen. Nach dem Abfiltrieren des Dicyclohexylharnstoffs wird eine viskose Harzlösung erhalten, die direkt zu Filmen und Folien weiter verarbeitet werden kann.

Durch Eintropfen der Harzlösung in destilliertes Wasser unter Rühren kann die photoreaktive Polyimid-Vorstufe aber auch als Festharz abgeschieden werden. Durch Filtration wird dann ein hellgelbes Pulver erhalten, das im Vakuum bei einem Druck von $1{,}3 \times 10^4$ Pa und einer Temperatur $\leq 40°C$

getrocknet wird. Die Viskositätszahl liegt bei 15,3 ml/g. Das IR-Spektrum zeigt die für Methacrylate typische Absorption bei 950 und 1 630 $cm^{-1}$.

Herstellung der Reliefstruktur

20 Gewichtsteile der auf die vorstehend beschriebene Weise als Festharz isolierten Polyimid-Vorstufe werden zusammen mit 0,4 Gewichtsteilen Azidosulfonylphenylmaleinimid und 0,4 Gewichtsteilen Michlers Keton sowie 0,2 Gewichtsteilen Vinyltriethoxysilan in 34 Volumenteilen N-Methylpyrrolidon gelöst und anschließend durch ein 0,8 µm-Filter druckfiltriert. Durch Aufgießen von ca. 2 ml der Lösung auf eine mit 3000 Umdrehungen/min rotierende Aluminiumscheibe wird ein homogener gelber Film erhalten, der im Vakuum (Druck : 1,3 × $10^4$ Pa) bei einer Temperatur von 50°C getrocknet wird. Die mit einem Alpha-step-Schichtdickenmeßgerät ermittelte Schichtdicke beträgt 5 µm. Der erhaltene Film wird dann mit einer 500 W-Quecksilberhöchstdrucklampe 30 s lang durch eine Kontaktmaske belichtet und anschließend mit N-Methylpyrrolidon 20 s lang entwickelt. Vorteilhaft ist es, insbesondere bei der Feinstrukturerzeugung, wenn mit Xylol nachgewaschen wird. Nach dem Entwickeln werden kantenscharfe Abbildungen erhalten ; Strukturen von 5 µm werden gut aufgelöst. Die Umwandlung der Reliefstrukturen in Polyimid-Reliefstrukturen durch einen Temperprozeß bei 400°C (Dauer : 30 min) führt zu einer Schichtdickenreduzierung, überraschender Weise aber zu keiner Beeinträchtigung der Abbildungsgenauigkeit.

Die auf die beschriebene Weise hergestellten Reliefstrukturen weisen die ausgezeichneten thermischen, elektrischen, chemischen und mechanischen Eigenschaften des Polyimids Polydiphenyletherpyromellithimid auf. Das IR-Spektrum zeigt die für Imide typische Bande bei 5,6 µm.

Beispiel 2

Herstellung einer strahlungsreaktiven Polyisoindolochinazolindion-Vorstufe.

Zu 43,6 Gewichtsteilen Pyrromellithsäuredianhydrid (0,2 Mol) in 100 Volumenteilen N-Methylpyrrolidon werden unter Rühren und Feuchtigkeitsausschluß 46,4 Gewichtsteile Hydroxyethylacrylat (0,4 Mol) und 0,4 Gewichtsteile 1.4-Diazabicyclo(2.2.2)octan gegeben. Die Reaktionslösung wird dann 15 h bei Raumtemperatur stehengelassen. Zu der Lösung des Diesters werden danach 51,7 Gewichtsteile 4.4'-Diaminodiphenyl-3.3'-dicarbonsäureamid (0,19 Mol) in 100 Volumenteilen eines Dimethylacetamid/N-Methylpyrrolidon-Gemisches (Volumen-verhältnis 1 :1) gegeben. Anschließend wird zu der Lösung unter Rühren und unter Kühlen eine Lösung von 74 Gewichtsteilen Dicyclohexylcarbodiimid (0,36 Mol) in 50 Volumenteilen N-Methylpyrrolidon getropft. Unter leichter Wärmetönung scheidet sich dabei Dicyclohexylharnstoff ab. Nach einer Nachreaktionszeit von 5 h wird der Dicyclohexylharnstoff durch Filtration abgetrennt.

Herstellung der Reliefstruktur

Zu 20 ml der erhaltenen viskosen Lösung werden 0,5 g N-Phenylmaleinimid, 0,2 g Michlers Keton und 0,1 g Vinyltrimethoxyethoxysilan gegeben. Die Lösung wird dann durch ein 0,8 µm-Filter filtriert und anschließend auf einer Siliciumscheibe mit einer Plasmanitridoberfläche bei 3500 Umdrehungen/min zu einem homogenen Film geschleudert. Nach dem Trocknen im Valuum (Druck : 1,3 × $10^4$ Pa) für die Dauer von 3 h bei einer Temperatur von 40°C beträgt die Schichtdicke 7 µm. Wird die beschichtete Siliciumscheibe durch eine Kontaktmaske mit einer 350 W-Quecksilberhöchstdruklampe belichtet, so werden - bei einer Belichtungszeit von 60 s - nach der Entwicklung mit N-Methylpyrrolidon (Dauer : 30 s) Reliefstrukturen erhalten, die durch 30 minütiges Tempern bei 430°C in Polyisoindolochinazolindion-Reliefstrukturen umgewandelt werden können. Die Qualität der Reliefstrukturen bleibt dabei unbeeinträchtigt.

**Patentansprüche**

1. Verfahren zur Herstellung hochwärmebeständiger Polyimid- und Polyisoindolochinazolindion-Reliefstrukturen durch

a) Auftragen strahlungsempfindlicher löslicher Polymer-Vorstufen in Form einer Schicht oder Folie auf ein Substrat, wobei als Polymer-Vorstufen olefinisch ungesättigte Polyamidocarbonsäureester dienen

b) Bestrahlen der Schicht bzw. Folie durch Negativvorlagen mit aktinischem Licht oder Elektronen oder durch Führen eines Licht-, Elektronen-, Ionen- oder Laserstrahls,

c) Entfernen der nichtbestrahlten Schicht- bzw. Folienteile und

d) gegebenenfalls nachfolgendes Tempern,

dadurch gekennzeichnet, daß als Polymer-Vorstufen in Gegenwart von Carbodiimiden hergestellte Polykondensationsprodukte von Diaminoverbindungen oder Diaminoverbindungen mit wenigstens einer ortho-ständigen Amidogruppe und olefinisch ungesättigten Tetracarbonsäurediestern in Form von

Additionsprodukten aus aromatischen und/oder heterocyclischen Tetracarbonsäuredianhydriden und olefinisch ungesättigten Alkoholen verwendet werden.

2. Verfahren nach Anspruch 1, dadurch gekennzeichnet, daß die Polymer-Vorstufen zusammen mit licht- oder strahlungsempfindlichen copolymerisationsfähigen Verbindungen eingesetzt werden, insbesondere mit N-substituierten Maleinimiden.

3. Verfahren nach Anspruch 1 oder 2, dadurch gekennzeichnet, daß die Polymer-Vorstufen zusammen mit Photoinitiatoren und/oder Photosensibilisatoren eingesetzt werden, insbesondere mit Michlers Keton, Benzimidazolen und/oder Ketocumarinen.

4. Verfahren nach einem der Ansprüche 1 bis 3, dadurch gekennzeichnet, daß Haftvermittler, insbesondere Silane, verwendet werden.

5. Verfahren nach einem oder mehreren der Ansprüche 1 bis 4, dadurch gekennzeichnet, daß ein Polykondensationsprodukt eines olefinisch ungesättigten Pyromellithsäure- und/oder Benzophenontetracarbonsäurediesters mit 4.4'-Diaminodiphenylether bzw. mit 4.4'-Diaminodiphenyl-3.3'-dicarbonsäureamid verwendet wird.

6. Verwendung der nach dem Verfahren nach einem oder mehreren der Ansprüche 1 bis 5 hergestellten Reliefstrukturen als Resist mit intermediärer Schutzfunktion zur lithographischen Strukturierung von Oberflächen, insbesondere bei Trockenätzverfahren.

7. Verwendung der nach dem Verfahren nach einem oder mehreren der Ansprüche 1 bis 5 hergestellten Reliefstrukturen zur dauerhaften Beschichtung oder Rasterung von Oberflächen.

8. Verwendung der nach dem Verfahren nach einem oder mehreren der Ansprüche 1 bis 5 hergestellten Reliefstrukturen als Schutz- und Isolierstoff in der Elektrotechnik.

9. Verwendung der nach dem Verfahren nach einem oder mehreren der Ansprüche 1 bis 5 hergestellten Reliefstrukturen als α-Strahlenschutz für Speicherbausteine.

10. Verwendung der nach dem Verfahren nach einem oder mehreren der Ansprüche 1 bis 5 hergestellten Reliefstrukturen als Orientierungsschicht in Flüssigkristallanzeigen.

**Claims**

1. A process for the production of highly heat resistant polyimide and polyisoindoloquinazolinedione relief structures by

a) application of radiation-sensitive, soluble polymer precursors in the form of a layer or film to a substrate, where olefinically unsatured polyamidocarboxylic acid esters serve as polymer precursors,

b) irradiation of the layer or film throught negative patterns using actinic light or electrons or by guiding a light, electron, ion or laser beam,

c) removal of the non-irradiated parts of the layer or film, and where necessary, subsequent annealing,

characterised in that the polymer precursors consist of polycondensation products, produced in the presence of carbodiimides, of diamino compounds, or diamino compounds with at least one ortho-positioned amido group, and olefinically-unsaturated tetracarboxylic acid diesters in the form of addition products of aromatic and/or heterocyclic tetracarboxylic acid dianhydrides and olefinically-unsaturated alcohols.

2. A process as claimed in Claim 1, characterised in that the polymer precursors are used together with light or radiation-sensitive, copolymerisable compounds, in particular N-substituted maleic acid imides.

3. A process as claimed in Claim 1 or 2, characterised in that the polymer precursors are used together with photo-initiators and/or photo-sensitisors, in particular Michler's ketone, benzimidazoles and/or ketocoumarins.

4. A process as claimed in one of Claims 1 to 3, characterised in that bonding agents, in particular silanes, are used.

5. A process as claimed in one or more of Claims 1 to 4, characterised in that a polycondensation product of an olefinically-unsaturated pyromellitic acid diester and/or benzophenonetetracarboxylic acid diester with 4.4'-diaminodiphenyl ether or with 4.4'-diaminodiphenyl-3.3'-dicarboxylic acid amide is used.

6. The use of the relief structures produced in accordance with the process claimed in one or more of Claims 1 to 5, as a resist with an intermediate protective function for the lithographic structuring of surfaces, in particular in dry etching processes.

7. The use of the relief structures produced in accordance with the process claimed in one or more of Claims 1 to 5, for the permanent coating or the patterning of surfaces.

8. The use of the relief structures produced in accordance with the process claimed in one or more of Claims 1 to 5 as protective and insulating means in electrotechnology.

9. The use of the relief structures produced in accordance with the process claimed in one or more of Claims 1 to 5. as α-radiation protection for memory modules.

10. The use of the relief structures produced in accordance with the process claimed in one or more of Claims 1 to 5, as orientation layer in liquid crystal displays.

**Revendications**

1. Procédé de préparation de structures en relief très résistantes à la chaleur, en polyimide et en polyisoindoloquinazolindione par

a) dépôt de précurseurs de polymère sensibles aux rayonnements et solubles, sous forme d'une couche ou d'une feuille, sur un substrat, en utilisant comme précurseurs de polymère des polyamidocarboxylates à insaturation oléfinique,

b) exposition de la couche ou de la feuille à travers des originaux négatifs, à de la lumière actinique ou à des électrons, ou par envoi d'un faisceau lumineux, d'un faisceau d'électrons, d'un faisceau d'ions ou d'un faisceau laser,

c) élimination des parties de la couche ou de la feuille qui n'ont pas été exposées, et

d) éventuellement recuit ultérieur,

caractérisé en ce qu'il consiste à utiliser, comme précurseurs de polymère, des produits de polycondensation, préparés en présence de carbodiimides, de composés diaminés ou de composés diaminés ayant au moins un groupe amido en position ortho, et de diesters d'acide tétracarboxylique à insaturation oléfinique, sous forme de produits d'addition de dianhydrides d'acide tétracarboxylique aromatique et/ou hétérocyclique et d'alcools à insaturation oléfinique.

2. Procédé suivant la revendication 1, caractérisé en ce qu'il consiste à mettre en œuvre les précurseurs de polymère en même temps que des composés aptes à copolymériser et sensibles à la lumière ou aux rayonnements, notamment des maléimides substitués sur l'azote.

3. Procédé suivant la revendication 1 ou 2, caractérisé en ce qu'il consiste à mettre en œuvre des précurseurs de polymère en même temps que des photoinitiateurs et/ou des photosensibilisateurs, notamment la cétone de Michler, des benzimidazoles et/ou des cétocoumarines.

4. Procédé suivant l'une des revendications 1 à 3, caractérisé en ce qu'il consiste à utiliser des agents de pontage, notamment des silanes.

5. Procédé suivant l'une ou plusieurs des revendications 1 à 4, caractérisé en ce qu'il consiste à utiliser un produit de condensation d'un diester d'acide pyromellitique et/ou d'acide benzophénonetétracarboxylique à insaturation oléfinique et de l'éther 4,4'-diaminodiphénylique ou de l'amide d'acide 4,4'-diaminodiphényl-3,3'-dicarboxylique.

6. Utilisation des structures en relief préparées par le procédé suivant l'une ou plusieurs des revendications 1 à 5, comme résist ayant une fonction intermédiaire de protection pour la structuration lithographique de surfaces, notamment dans des procédés de gravure à sec.

7. Utilisation de structures en relief préparées par le procédé suivant l'une ou plusieurs des revendications 1 à 5, pour le revêtement permanent ou le tramage de surfaces.

8. Utilisation de structures en relief préparées par le procédé suivant l'une ou plusieurs des revendications 1 à 5, comme substances de protection et isolantes en électrotechnique.

9. Utilisation des structures en relief préparées par le procédé suivant l'une ou plusieurs des revendications 1 à 5, comme agent protecteur vis-à-vis du rayonnement alpha pour des éléments de mémoire.

10. Utilisation des structures en relief préparées par le procédé suivant l'une ou plusieurs des revendications 1 à 5, comme couches d'orientation dans des dispositifs d'affichage à cristal liquide.